(19) Europäisches Patentamt
European Patent Office
Office européen des brevets

(11) **EP 3 770 624 B1**

(12) **EUROPÄISCHE PATENTSCHRIFT**

(45) Veröffentlichungstag und Bekanntmachung des Hinweises auf die Patenterteilung:
**22.03.2023  Patentblatt 2023/12**

(21) Anmeldenummer: **19188305.7**

(22) Anmeldetag: **25.07.2019**

(51) Internationale Patentklassifikation (IPC):
*G01R 33/36* *(2006.01)*    *G01R 33/565* *(2006.01)*
*G01R 33/48* *(2006.01)*    *G01R 33/24* *(2006.01)*
*G01R 33/3415* *(2006.01)*

(52) Gemeinsame Patentklassifikation (CPC):
**G01R 33/565; G01R 33/36;** G01R 33/243;
G01R 33/3415; G01R 33/4824

(54) **VERFAHREN UND VORRICHTUNGEN ZUM BERÜCKSICHTIGEN DES MAGNETRESONANZSIGNALS BEI EINER STÖRUNTERDRÜCKUNG**

METHODS AND DEVICES FOR ACCOUNTING FOR THE MAGNETIC RESONANCE SIGNAL IN INTERFERENCE SUPPRESSION

PROCÉDÉS ET DISPOSITIFS DE PRISE EN COMPTE DU SIGNAL DE RÉSONANCE MAGNÉTIQUE LORS D'UN ANTIPARASITAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**27.01.2021  Patentblatt 2021/04**

(73) Patentinhaber: **Siemens Healthcare GmbH 91052 Erlangen (DE)**

(72) Erfinder:
• **Biber, Stephan**
  **91056 Erlangen (DE)**
• **Grodzki, David**
  **91058 Erlangen (DE)**

(56) Entgegenhaltungen:
EP-A1- 3 467 531        JP-A- 2018 201 599
US-A1- 2004 164 739    US-A1- 2008 048 658

**Beschreibung**

Die Erfindung betrifft ein Verfahren zur aktiven Störunterdrückung in einem Magnetresonanztomographen sowie einen Magnetresonanztomographen mit einem Empfänger. Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Zum Empfang des Signals werden vorzugsweise lokale Empfangsantennen, sogenannte Lokalspulen verwendet, die zur Erzielung eines besseren Signal-Rauschabstandes unmittelbar am Untersuchungsobjekt angeordnet werden. Die Empfangsantennen können auch in einer Patientenliege verbaut sein.

Magnetresonanztomographen erfordern in zweierlei Hinsicht eine Hochfrequenzabschirmung. Zum einen werden zur Anregung der Kernspins Hochfrequenzimpulse mit Leistungen im Kilowattbereich erzeugt, die nur teilweise im Patienten absorbiert werden. Radiowellen, die die Patientendurchführung verlassen, werden in den Raum abgestrahlt und müssen daher zur Einhaltung von Emissionsgrenzwerten abgeschirmt werden.

Zum anderen sind die für die Bildgebung zu empfangenden Magnetresonanzsignale extrem schwach. Um hier ein ausreichendes Signal-zu-Rausch-Verhältnis (SNR) zu erreichen, ist eine Abschirmung externer Störsignale erforderlich.

Aus dem Dokument EP-A-3 467 531 ist ein Magnetresonanztomograph sowie ein Verfahren zum Betrieb des Magnetresonanztomographen bekannt. Der Magnetresonanztomograph weist eine erste Empfangsantenne zum Empfang eines Magnetresonanzsignals aus einem Patienten in einem Patiententunnel, eine zweite Empfangsantenne zum Empfang eines Signals mit der Larmorfrequenz des Magnetresonanzsignals und einen Empfänger auf. Die zweite Empfangsantenne ist außerhalb oder in der Nähe einer Öffnung des Patiententunnels angeordnet. Der Empfänger steht in Signalverbindung mit der ersten Empfangsantenne und der zweiten Empfangsantenne und ist ausgelegt, ein mit der zweiten Empfangsantenne empfangenes Störsignal in einem von der ersten Empfangsantenne empfangenen Magnetresonanzsignal zu unterdrücken.

Das Dokument JP 2018-201599 A offenbart eine Störunterdrückungsvorrichtung, die eine Frequenzschätzvorrichtung, eine Phasenschätzvorrichtung, einen Generator für periodische Signale, eine Amplitudenschätzvorrichtung, eine Signalreplikationsvorrichtung und eine Unterdrückungsvorrichtung auf. Mit der Frequenzschätzvorrichtung, der Phasenschätzvorrichtung und der Amplitudenschätzvorrichtung werden eine Frequenz, Phase und periodische Amplitudenänderung einer Störung bestimmt, mit dem Generator für periodische Signale und der Signalreplikationsvorrichtung anhand der ermittelten Frequenz, Phase und Amplitudenänderung ein Störsignal synthetisiert und damit in der Unterdrückungsvorrichtung ein Störsignal in einem Empfangssignal unterdrückt.

Das Dokument US 2008/0048658 A1 schlägt eine Signalverarbeitungsvorrichtung für eine aktive Unterdrückung von elektromagnetischen Störsignalen aus einer Umgebung vor. Das System verwendet einen Störsignalsensor außerhalb eines Bilderfassungsvolumens, um das elektromagnetische Störsignal in der Umgebung zu erfassen und zieht das korrelierte Störsignal in dem Umgebungssignal von dem Bilderfassungssignal ab. Z-Es wird auch empfohlen, das im Bildgebungsvolumen erfasste MR-Signal herunterzuskalieren und vom Störsignal abzuziehen, um zu verhindern, dass das interessierende Signal als Rauschen interpretiert wird.

Es werden im Stand der Technik um einen Magnetresonanztomographen aufwändige Schirmkabinen installiert, um sowohl Emissionen als auch Immissionen zu reduzieren.

Es könnte daher eine Aufgabe der Erfindung sein, den Aufwand für eine Abschirmung zu reduzieren.

Die Aufgabe wird durch ein erfindungsgemäßes Verfahren zum Betrieb des Magnetresonanztomographen nach Anspruch 1, 2 und 3 gelöst, sowie mit einem Magnetresonanztomographen nach Anspruch 6, 7 und 8.

Das erfindungsgemäße Verfahren ist zum Unterdrücken von Störsignalen bei einer Magnetresonanzaufnahme mit einem Magnetresonanztomographen vorgesehen. Als Unterdrücken von Störsignalen wird hierbei nicht lediglich eine passive Reduzierung durch Abschirmmaßnahmen angesehen, sondern durch Schritte und Maßnahmen in der Verarbeitung der empfangenen Signale. Der Magnetresonanztomograph weist eine Steuerung und einen Empfänger auf. Der Empfänger ist dabei ausgelegt, die zur Bildgebung erforderlichen Magnetresonanzsignale von einer oder mehreren Antennen aufzunehmen und für eine nachfolgende Bildrekonstruktion aufzubereiten. Dies kann beispielsweise Verstärken und Filtern umfassen. Der Empfänger ist dabei insbesondere ausgelegt, Magnetresonanzsignale bei der Larmorfrequenz zu verarbeiten, wobei die Larmorfrequenz durch ein statisches Magnetfeld B0 des Magnetresonanztomographen und das magnetische Moment bzw. den Spin der zu erfassenden Kerne vorbestimmt ist.

Das Magnetresonanzsignal wird von einer oder mehreren Antennen, beispielsweise einer Lokalspule mit Antennenspulen oder einer Körperspule empfangen. Der Empfänger kann dabei einzelne Empfangskanäle je Antennenspule oder auch Empfangskanäle für kombinierter Signale mehrerer Antennen aufweisen. Als Magnetresonanzsignal der Antennen wird dabei ein Signal angesehen, das zumindest überwiegend durch eine Resonanz von angeregten Kernspins der zu untersuchenden Kerne erzeugt wird. Unvermeidlich ist dabei ein Anteil von Rauschen oder anderen Störsignalen, die jedoch gegenüber dem Signal der Kernspins um 12 dB, 18 dB, 24 dB, 36 dB oder mehr gedämpft sind.

Der Magnetresonanztomograph weist weiterhin einen oder mehrere Störsignalsensoren auf. Als Störsignalsensor wird eine Antenne oder Sensor angesehen, die bzw. der das Störsignal stärker aufnimmt als das Magnetresonanzsignal, beispielsweise um 6 dB, 12 dB, 18 dB oder mehr über dem Magnetresonanzsignal. Der Störsignalsensor kann dabei eine Antenne sein, die beispielsweise durch ihre Position außerhalb des Patiententunnels bevorzugt das Störsignal aufnimmt. Denkbar ist aber auch ein dedizierter Sensor, wie eine Induktionsspule, die ein Störsignal von einer Zuleitung abgreift.

In einem Schritt des erfindungsgemäßen Verfahrens empfängt der Empfänger über den Störsignalsensor ein Referenzstörsignal. In einem anderen Schritt empfängt der Empfänger über die Antenne das Magnetresonanzsignal. Das Erfassen des Referenzstörsignals kann dabei zeitlich getrennt, d.h. während disjunkter Zeitabschnitte, von dem Erfassen des MR-Signals erfolgen, sodass der Störsignalsensor auch eine Antenne zur Bilderfassung sein kann. Oder es erfolgt eine räumliche Trennung durch einen Störsignalsensor, der auch räumlich von der Antenne für den Empfang des MR-Signals beabstandet ist.

Dabei ist es denkbar, dass auch das Referenzstörsignal einen kleinen Anteil des Magnetresonanzsignals aufweist, wie bereits zu dem Störsignalsensor erläutert. Es ist sowohl möglich, dass beide Signale gleichzeitig empfangen werden, aber auch denkbar, dass die beiden Signale zu unterschiedlichen Zeiten oder abwechselnd gleichzeitig und getrennt empfangen werden. Als Magnetresonanzsignal wird insbesondere bei zeitlicher Trennung die empfangene Emission der Kernspins bezeichnet, auch wenn diese nicht weiter zur Bildgebung genutzt wird. Aufgrund des exponentiellen Abfalls der Signale der Kernspins mit der Zeit sind auch außerhalb der für die Bildgebung genutzten Empfangsfenster Magnetresonanzsignale vorhanden, auch wenn deren Intensität geringer ist.

In einem weiteren Schritt reduziert der Empfänger einen Anteil des Störsignals in dem Magnetresonanzsignal in Abhängigkeit von dem Referenzstörsignal. Beispielsweise kann der Empfänger das Referenzstörsignal des Störsignaldetektors mit einem Verstärker um einen Faktor verstärken und derart mit einem Verzögerungsglied in der Phase verzögern, dass es gerade in dem Betrag der Amplitude dem Anteil des Störsignals in dem Magnetresonanzsignal der Antenne entspricht und ein umgekehrtes Vorzeichen hat. Beispielsweise durch ein Summationsglied kann so durch Addieren beider Signale der Anteil des Störsignals in dem Magnetresonanzsignal reduziert werden, idealerweise nahezu auf Null. Der Empfänger und/oder die Steuerung ermitteln dazu die Dämpfung des Störsignals in dem Magnetresonanzsignal sowie die Phasenverschiebung, beispielsweise durch Autokorrelation von Magnetresonanzsignal und Referenzstörsignal.

Es wird aber dabei immer auch ein kleiner Anteil des Magnetresonanzsignals in dem Referenzstörsignal enthalten sein, zumindest wenn die Ermittlung von Dämpfung und Phasenverschiebung des Störsignals im Magnetresonanzsignal während einer Bildgebung ermittelt oder angepasst werden, da der Abfall des Magnetresonanzsignals exponentiell ist und damit zumindest theoretisch nie ganz bis Null geht. Der von dem Störsignalsensor empfangener Anteil des Magnetresonanzsignals würde bei einer einfachen Störunterdrückung fälschlicherweise als Störsignal interpretiert, von dem über die Antenne empfangenen Magnetresonanzsignal abgezogen und so zu einer Verschlechterung bzw. zu Artefakten in der Bildgebung führen.

Deshalb sieht das erfindungsgemäße Verfahren weiterhin den Schritt vor, das Reduzieren des Störsignals in Abhängigkeit von einem Anteil des Magnetresonanzsignals in dem von dem Störsignalsensor empfangenen Referenzstörsignal auszuführen, mit anderen Worten, einen Einfluss des Magnetresonanzsignals auf das Referenzstörsignal zu ermitteln oder abzuschätzen und in der nachfolgenden Ermittlung der Parameter, wie z.B. Dämpfung und/oder Phasenverschiebung für die Störunterdrückung in dem Magnetresonanzsignal, zu berücksichtigen. Verschiedene Möglichkeiten dazu sind in den abhängigen Ansprüchen angegeben.

Auf vorteilhafte Weise ermöglicht das erfindungsgemäße Verfahren, Artefakte durch die Störunterdrückung so zu reduzieren oder zu verhindern. Gemäss einem Aspekt des erfindungsgemäßen Verfahrens weist das Verfahren den Schritt auf, mittels einer Magnetresonanz-Messung einen k-Raum mit Messdaten einer Bilderfassung zu füllen. Dies kann beispielsweise mit einer klassischen Bilderfassung mittels Gradienten-Echo-Sequenz erfolgen, bei der der k-Raum zeilenweise abgetastet wird.

In einem weiteren Schritt wird aus diesen k-Raum-Messdaten ein Magnetresonanzsignal zu einem jeweiligen Zeitpunkt der Erfassung des Referenzstörsignals ermittelt. Da das Erfassen des Referenzstörsignals nicht notwendigerweise gleichzeitig mit einem Erfassen eines Magnetresonanzsignals erfolgt, das dann einem Punkt im k-Raum entspricht, ist es notwendig, das Magnetresonanzsignal während der Erfassung des Referenzstörsignals aus den k-Raum-Daten zwischen den Messpunkten zu interpolieren.

Erfindungsgemäss wird dazu ein Verfahren verwendet, das auch als Gridding bezeichnet wird. Gridding wird üblicherweise verwendet, um Messdaten aus einer spiralförmigen oder radialen Abtastung für eine vereinfachte Fourier-Transformation in den Bildraum auf eine virtuelle Abtastung in Zeilen eines kartesischen Gitters des k-Raums umzusetzen (siehe auch Handbook of MRI Pulse Sequences; Bernstein, King, Zhou; Elsevier Academic Press, ISBN-13:978-0-12-092861-3, Kapitel 13.2). In einer Ausführungsform des vorliegenden erfindungsgemäßen Verfahrens hingegen wird Gridding genutzt, um das MR-Signal zu dem Zeitpunkt der Erfassung des Referenzstörsignals bestimmen. Mit dem so bestimmten Anteil des Magnetresonanzsignals in dem von dem Störsignalsensor empfangenen Referenzstörsignal kann beispielsweise durch Differenzbildung oder ein adaptives Filter ein Referenzstörsignal ohne Magnetresonanzanteil ermittelt werden. Aus diesem gefilterten Referenzstörsignal werden dann wiederum durch die Steuerung oder den Empfänger Parameter für eine Unterdrückung des Störsignals in dem Magnetresonanzsignal ermittelt, beispielsweise die Verstärkung und/oder Phasenverschiebung. Indem durch das erfinderische Verfahren Störsignal und Magnetresonanzsignal getrennt ermittelt werden, ist es beispielsweise denkbar, dass das von dem Störsignalsensor empfangene Störsignal mit z.B. adaptiven Filtern oder durch Subtraktion des ermittelten Magnetresonanzsignalanteils von dem Anteil des Magnetresonanzsignals befreit wird, bevor es zur Störunterdrückung mit dem Magnetresonanzsignal der Antennen kombiniert wird. Es wäre aber auch denkbar, die Störunterdrückung des von der Antenne empfangenen Magnetresonanzsignals selbst beispielsweise durch adaptive Filter so zu parametrisieren, dass bei der Störunterdrückung ein Magnetresonanzsignalanteil im Störsignal unberücksichtigt bleibt.

Auf vorteilhafte Weise lassen sich so Artefakte durch ein als Störsignal interpretiertes MR-Signal reduzieren, ohne zusätzliche, zeitaufwändige MR-Messungen vornehmen zu müssen.

Gemäss eines alternativen Aspekts des erfindungsgemäßen Verfahrens weist das Verfahren den Schritt auf, mittels einer MR-Messung quantitative Informationen über das zu untersuchende Objekt zu ermitteln. Derartige quantitative Informationen können beispielsweise T1- und/oder T2-Maps entnommen werden, die im Rahmen eines Fingerprinting zur Vorbereitung einer Bilderfassung ermittelt werden.

Aus den quantitativen Informationen wird in einem Schritt des erfindungsgemäßen Verfahrens ein Anteil des Magnetresonanzsignals in dem Referenzstörsignal bestimmt. Beispielsweise ist es denkbar, dass aufgrund der ermittelten quantitativen Informationen ein MR-Signal des Untersuchungsobjektes mittels Bloch-Gleichungen simuliert bzw. synthetisiert wird, um das so ermittelte Magnetresonanzsignal von dem Referenzstörsignal abzuziehen bzw. bei der Reduzierung des Störsignals in dem Magnetresonanzsignal zu berücksichtigen.

Auf vorteilhafte Weise erlaubt auch ein aus quantitativen Informationen zuvor gewonnenes, synthetisches Magnetresonanzsignal einen Anteil des Magnetresonanzsignals am Referenzstörsignal zu bestimmen und bei der Störunterdrückung zu berücksichtigen, um Artefakte durch die Störunterdrückung zu reduzieren.

In einem weiteren Aspekt des erfindungsgemäßen Verfahrens weist der Magnetresonanztomograph eine Mehrzahl an Antennen zum Empfang des Magnetresonanzsignals auf. Dabei wird bei dem Schritt des Reduzierens eines Anteils des Störsignals in dem Magnetresonanzsignal einer ersten Antenne durch den Empfänger dies in Abhängigkeit von dem Referenzstörsignal und einem Magnetresonanzsignal einer zweiten Antenne ausgeführt. Zu dem Unterdrücken in Abhängigkeit von dem Referenzstörsignal sei auf die vorhergehenden Ausführungen verwiesen. Darüber hinaus wird beim Unterdrücken auch auf die Signale einer zweiten Antenne und/oder weiterer Antennen zurückgegriffen. Dabei kann durch Korrelation der von den Antennen empfangenen Signale auf das Störsignal geschlossen werden. Beispielsweise kann durch unterschiedliche räumliche Anordnung der Antennen das Störsignal zwischen den Antennen jeweils in der Phase verschoben sein, sodass durch Korrelation der Signale der Antennen eine Phasenverschiebung ermittelt wird und entsprechend die unterschiedliche Phasenverschiebung auf das Signal des Störsignalsensors angewendet wird, bevor es zur Reduzierung des Störsignals von dem Magnetresonanzsignal der jeweiligen Antenne subtrahiert wird.

Das Magnetresonanzsignal an dem Störsignalsensor wird dabei durch eine gewichtete Summe über die erste Antenne, die zweite Antenne und gegebenenfalls weitere Antennen mit jeweils unterschiedlicher Phasenverschiebung näherungsweise abgeschätzt, um es dann von dem empfangenen Signal des Störsignalsensors abzuziehen.

Auf vorteilhafte Weise ermöglicht das Einbeziehen der Signale einer zweiten oder weiterer Antenne beim Reduzieren des Störsignals in dem Magnetresonanzsignal der ersten Antenne eine genauere Abschätzung und damit verringerte Bildartefakte.

Vorteilhafte Ausführungsformen der Erfindung sind in den Unteransprüchen angegeben.

In einer möglichen Ausführungsform weist das Verfahren einen Schritt auf, eine Transferfunktion des Magnetresonanzsignals von dem Untersuchungsobjekt zu dem Störsignalsensor zu bestimmen. Es ist dazu denkbar, anhand der Maxwellschen Feldgleichungen eine Feldstärke des Magnetresonanzsignals am Ort des Störsignaldetektors zu errechnen. Denkbar wäre es aber auch, wie zuvor beschrieben bei abgeschätztem MR-Signal am Ort des Untersuchungsobjektes dieses durch Autokorrelation in dem Signal des Störsignalsensors zu erkennen und so eine Transferfunktion zu bestimmen.

Denkbar wäre es auch, eine Messung des Signals am Störsignalsensor bei gleichen Bedingungen mehrfach zu wiederholen, d.h. mit gleicher Anregungssequenz und gleicher geometrischer Anordnung. Ein statistisches Störsignal würde sich dann herausmitteln, während ein immer wieder gleicher Magnetresonanzsignalanteil durch Überlagerung anwächst und daraus die Transferfunktion bestimmt werden kann.

Eine einmal ermittelte Transferfunktion kann dann als konstant angenommen werden, insbesondere für eine Bilderfassung mit gleichem Untersuchungsobjekt und gleicher Anordnung. Bei Änderungen könnte dann der Schritt zur Ermittlung der Transferfunktion wiederholt werden.

Die Transferfunktion erlaubt auf vorteilhafte Weise mit dem ermittelten Magnetresonanzsignal einen Anteil des Magnetresonanzsignals an dem Signal des Störsignalsensors genauer vorherzusagen.

In einer möglichen Ausführungsform des erfindungsgemäßen Verfahrens weist der Magnetresonanztomograph eine Feldkamera auf. Als Feldkamera wird hierbei eine Vorrichtung bezeichnet, die ausgelegt ist, das Magnetfeld, insbesondere dabei das zeitlich veränderliche Gradientenfeld, in einer Umgebung des Untersuchungsobjektes aufzuzeichnen, um so beispielsweise Abweichungen durch Wirbelströme oder auch das Untersuchungsobjekt selbst zu detektieren. Die Feldkamera zeichnet während einer Magnetresonanzmessung den zeitlichen Verlauf des Gradientenfeldes auf. Anschließend wird von der Steuerung bzw. dem Empfänger der Anteil des Magnetresonanzsignals in dem Referenzstörsignal in Abhängigkeit von dem von der Feldkamera aufgezeichneten zeitlichen Verlauf des Gradientenfeldes bestimmt. Dies kann beispielsweise durch das bereits erläuterte Gridding erfolgen, wobei die k-Raum-Positionen der Messungen anhand des von der Feldkamera aufgezeichneten Magnetfeldes korrigiert werden. Bei einer Simulation der Magnetresonanzsignale mit Hilfe von quantitativen Informationen werden die korrigierten Magnetfeldwerte entsprechend der Aufzeichnung der Feldkamera beispielsweise für die Bloch-Gleichungen verwendet.

Auf vorteilhafte Weise erlaubt das Aufzeichnen der Gradientenfelder mit einer Feldkamera eine genauere Ermittlung des Anteils des Magnetresonanzsignals in dem Referenzstörsignal und damit eine bessere Korrektur.

In einer denkbaren Ausführungsform des erfindungsgemäßen Verfahrens weist der Magnetresonanztomograph eine Mehrzahl an Antennen zum Empfang des Magnetresonanzsignals auf. Dies können beispielsweise mehrere Antennenspulen einer Lokalspulenmatrix sein, mehrere separate Lokalspulen, die an unterschiedlichen Positionen angeordnet sind oder auch eine oder mehrere Lokalspulen und die Körperspule.

Bezüglich des Reduzierens eines Anteils des Störsignals in dem Magnetresonanzsignal einer ersten Antenne durch den Empfänger wird auf die bisherigen Ausführungen verwiesen. Darüber hinaus wird gemäß einem Aspekt der vorliegenden Ausführungsform zumindest auch das von einer zweiten Antenne aufgenommene Magnetresonanzsignal zur Störunterdrückung genutzt. Dabei erfolgt die Störunterdrückung in Abhängigkeit von dem Referenzstörsignal und einem Magnetresonanzsignal der zweiten Antenne. Dabei wird ausgenutzt, dass die erste Antenne und die zweite Antenne räumlich gegeneinander versetzt sind, insbesondere was den Abstand zu dem Störsignalsensor angeht. Damit ist auch ein Störsignal, das von dem Störsignalsensor aufgenommen wurde, bei seinem Empfang durch die erste und die zweite Antenne um einen gewissen Phasenbetrag verschoben, der einer Abstandsdifferenz geteilt durch die Ausbreitungsgeschwindigkeit entspricht. In umgekehrter Richtung trifft ein Magnetresonanzsignal, das jeweils von erster Antenne und zweiter Antenne erfasst wurde, mit entsprechender Phasenverzögerung ein. So kann beispielsweise das Magnetresonanzsignal an dem Störsignalsensor durch eine gewichtete Summe über die erste Antenne, die zweite Antenne und gegebenenfalls weitere Antennen mit jeweils unterschiedlicher Phasenverschiebung näherungsweise abgeschätzt werden, um es dann von dem empfangenen Signal des Störsignalsensors abzuziehen.

Auf vorteilhafte Weise ermöglicht das Einbeziehen der Signale einer zweiten oder weiterer Antennen beim Reduzieren des Störsignals in dem Magnetresonanzsignal der ersten Antenne eine genauere Abschätzung und damit verringerte Bildartefakte.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:

Fig. 1    eine schematische Darstellung eines Magnetresonanztomographen zum Ausführen des erfindungsgemäßen Verfahrens;

Fig. 2    eine schematische Darstellung eines beispielhaften Ablaufdiagramms des erfindungsgemäßen Verfahrens;

Fig. 3    eine schematische Darstellung eines beispielhaften Ablaufdiagramms des erfindungsgemäßen Verfahrens.

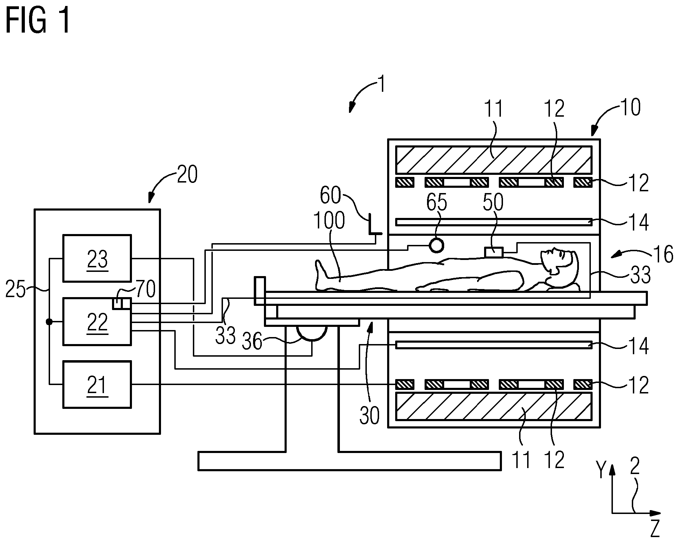

Fig. 1 zeigt eine schematische Darstellung einer Ausführungsform eines Magnetresonanztomographen 1 mit einer erfindungsgemäßen Lokalspule 50.

Die Magneteinheit 10 weist einen Feldmagneten 11 auf, der ein statisches Magnetfeld B0 zur Ausrichtung von Kernspins von Proben bzw. des Patienten 100 in einem Aufnahmebereich erzeugt. Der Aufnahmebereich zeichnet sich durch ein äußerst homogenes statisches Magnetfeld B0 aus, wobei die Homogenität insbesondere die Magnetfeldstärke bzw. deren Betrag betrifft. Der Aufnahmebereich ist nahezu kugelförmig und in einem Patiententunnel 16 angeordnet, der sich in einer Längsrichtung 2 durch die Magneteinheit 10 erstreckt.

Eine Patientenliege 30 ist in dem Patiententunnel 16 von der Verfahreinheit 36 bewegbar. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Feldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung zugeführtes Hochfrequenzsignal in das Untersuchungsvolumen abzustrahlen und von dem Patient 100 emittierte Resonanzsignale zu empfangen und über eine Signalleitung abzugeben.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die Anregungspulse können über die Körperspule 14 oder auch über eine lokale Sendeantenne in den Patienten 100 abgestrahlt werden.

Eine Steuerung 23 kommuniziert über einen Signalbus 25 mit der Gradientensteuerung 21 und der Hochfrequenzeinheit 22.

Auf dem Patienten 100 ist als eine erste Antenne eine Lokalspule 50 angeordnet, die über eine Anschlussleitung 33 mit der Hochfrequenzeinheit 22 und deren Empfänger verbunden ist. Denkbar ist es aber auch, dass die Körperspule 14 eine erste Antenne im Sinne der Erfindung ist.

An einem Rand der Öffnung des Patiententunnels 16 sind vier Störsignalsensoren 60 angeordnet, die an den Ecken eines Quadrates angeordnet sind, das der kreisförmigen Öffnung einbeschrieben ist, sodass die Ecken auf dem Rand der Öffnung zu liegen kommen.

Die vier Störsignalsensoren 60 stehen in Signalverbindung mit dem Empfänger 70 der Hochfrequenzeinheit 22. Aufgrund der Mehrzahl der Störsignalsensoren 60 ist es dabei denkbar, dass diese nicht alle eine Rundum-Empfangscharakteristik aufweisen, sondern beispielsweise Dipole sind und sich durch die unterschiedliche Ausrichtung zu einer Rundum-Charakteristik ergänzen. Es wäre aber beispielsweise auch denkbar, als einzige zweite Antenne mit Rundum-Charakteristik einen Kreuzdipol vorzusehen.

Es ist auch möglich, dass alternativ oder zusätzlich ein Störsignalsensor 60 in der Patientenliege 30 angeordnet ist.

Der Patiententunnel hat dabei vorzugsweise einen Radius R für den gilt:

$$R < (Lambda_L * 1,841)/(2*Pi)$$

$Lambda_L$ gibt dabei die Wellenlänge einer Radiowelle in Luft bei der Larmorfrequenz des Magnetresonanztomographen 1 an. Ist der Radius R kleiner als der rechte Term, so breitet sich die Radiowelle in dem Patiententunnel 16 exponentiell gedämpft aus und das Störsignal ist in der Mitte im Untersuchungsbereich FoV stark gedämpft. $Lambda_L$ wird auch als Grenzwellenlänge eines Rundhohlleiters bezeichnet, die dazugehörige Frequenz als Grenzfrequenz.

Lediglich der Patient 100 wirkt durch seine endliche Leitfähigkeit als Seele eines Koaxialkabels, dessen Mantel die Wand des Patiententunnels 16 ist, und leitet ein bei den Beinen oder dem Kopfende eingekoppeltes elektromagnetisches Signal in den Untersuchungsbereich weiter. Der Störsignalsensor 60 bzw. die Störsignalsensoren 60 in der Nähe der Öffnung oder in der Patientenliege 30 nehmen dabei auf vorteilhafte Weise das von dem Patienten 100 in den FoV weitergeleitete Störsignal auf und machen dadurch die Kompensation in dem Empfänger 70 besonders effektiv.

Allerdings leitet der Patient 100 auch in umgekehrter Richtung ein Magnetresonanzsignal aus dem Patiententunnel 16 zu dem bzw. den Störsignalsensoren 60. Wird dieses von dem Störsignalsensor 60 aufgenommen und wie ein externes Störsignal behandelt, d.h. in dem von der Lokalspule 50 und/oder Körperspule 14 empfangenen Magnetresonanzsignal beispielsweise abgezogen, so führt dies zu Verfälschungen des Magnetresonanzsignals und durch den Bezug zu dem bildgebenden Magnetresonanzsignal zu Bildartefakten.

Die Steuerung 23 und/oder der Empfänger 70 des erfindungsgemäßen Magnetresonanztomographen sind daher ausgelegt, das Reduzieren des Störsignals in Abhängigkeit von einem Anteil des Magnetresonanzsignals in dem von dem Störsignalsensor 60 empfangenen Referenzstörsignal vorzunehmen.

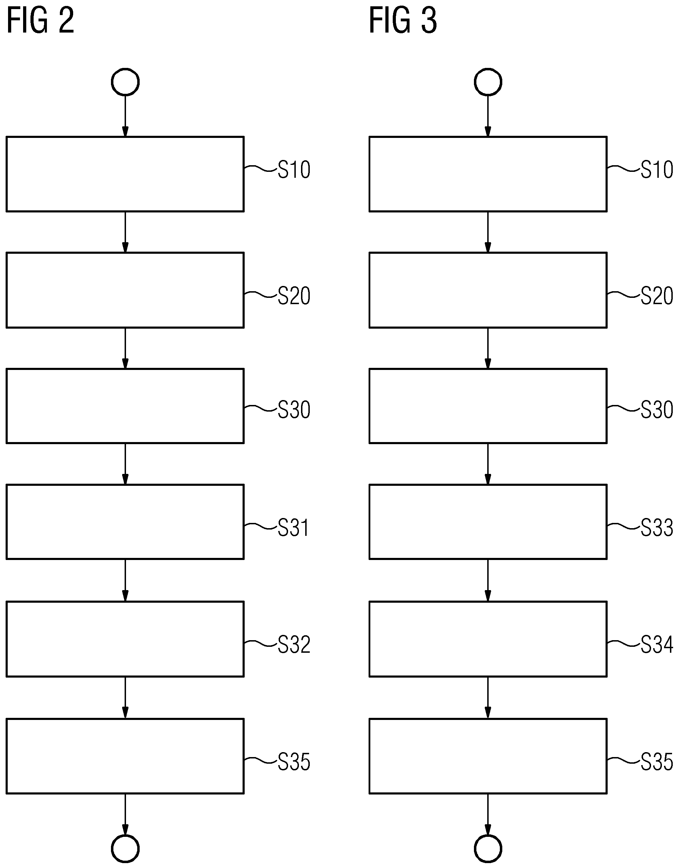

Dazu führen der Empfänger 70 und/oder die Steuerung 23 das in Fig. 2 dargestellte erfindungsgemäße Verfahren aus. Es ist dabei denkbar, dass das Verfahren programmgesteuert von einem Prozessor, vorzugsweise einem Signalprozessor, ausgeführt wird. Es ist aber ebenfalls denkbar, die Erfindung durch eine Logik in einem FPGA oder ASIC zu realisieren.

In einem Schritt S10 des erfindungsgemäßen Verfahrens empfängt der Empfänger 70 ein Referenzstörsignal über den Störsignalsensor 60. Das Referenzstörsignal weist dabei auch einen Anteil eines Magnetresonanzsignals auf, das von dem Patienten 100 abgestrahlt wird, selbst wenn gleichzeitig kein Magnetresonanzsignal über die Lokalspule 50 oder die Körperspule aufgenommen wird, denn durch den exponentiellen Abfall des Magnetresonanzsignals ist diese abgeschwächt noch längere Zeit vorhanden.

In einem Schritt S20 empfängt der Magnetresonanztomograph 1 ein Magnetresonanzsignal aus dem Patienten 100 mit dem Empfänger 70 über eine Antenne, beispielsweise die Lokalspule 50, die auch als Lokalspulenmatrix mit mehreren Antennenspulen ausgelegt sein kann, oder die Körperspule 14. Der Schritt S10 und der Schritt S20 erfolgen nicht notwendigerweise gleichzeitig, sondern können auch nacheinander stattfinden. Das empfangene Magnetresonanzsignal wird nach der Verarbeitung gemäß dem erfindungsgemäßen Verfahren weiter zur Bildgebung durch die Steuerung 23 oder eine separate Einheit zur Bildrekonstruktion verwendet und beispielsweise abschließend auf einem Bildschirm ausgegeben.

In einem Schritt S30 reduziert der Empfänger 70 einen Anteil des Störsignals in dem Magnetresonanzsignal in Abhängigkeit von dem Referenzstörsignal. Dies kann beispielsweise erfolgen, indem das Signal, das von dem Störsignalsensor 60 empfangen wird, mit einer vorbestimmten Gewichtung und Phasenverschiebung zu dem Signal der Lokalspule 50 addiert wird, sodass sich gerade die Anteile des Störsignals in dem Signal der Lokalspule 50 mit dem gewichteten Signal aufheben. Die Phasenverschiebung und Gewichtung kann beispielsweise durch Autokorrelation der Signale von Störsignal und Signal der Lokalspule 50 ermittelt werden.

Das erfindungsgemäße Verfahren zeichnet sich jedoch insbesondere dadurch aus, dass in Schritt S30 dabei auch berücksichtigt wird, dass in dem Signal des Störsignalsensors 60 immer auch ein Anteil eines Magnetresonanzsignals enthalten ist, zumindest während einer Bilderfassung mit einem Patienten 100. Deshalb sieht das erfindungsgemäße Verfahren vor, den Schritt S30 in Abhängigkeit von einem Anteil des Magnetresonanzsignals in dem von dem Störsignalsensor 60 empfangenen Referenzstörsignal auszuführen.

Dies kann dadurch erreicht werden, dass in einer Ausführungsform des erfindungsgemäßen Verfahrens mittels einer Magnetresonanz-Messung S31 ein k-Raum mit Messdaten einer Bilderfassung wie z.B. einer Gradienten-Echo-Sequenz befüllt wird. Die Magnetresonanz-Messung kann dabei als Teil einer Sequenz oder als vorbereitende Messung erfolgen. Dies kann im einfachsten Fall ein kartesisches Gitter im k-Raum sein, dessen Knotenpunkte zeilen- und spaltenweise mit MR-Signalen durch geeignete Sequenzen gefüllt werden. Denkbar sind aber auch andere Abtastungsschemata entlang radialer oder spiralförmiger Trajektorien.

In einem Schritt S32 kann dann durch Interpolation auf diesen k-Raumpunkten das MR-Signal zu jedem beliebigen Zeitpunkt interpoliert werden. Entsprechende Verfahren wurden entwickelt, um beispielsweise bei einer spiralförmigen Trajektorie die Messwerte für ein kartesisches Koordinatensystem zu ermitteln (auch als "Gridding" bezeichnet) und dann eine einfachere Rücktransformation in den Bildraum zu nutzen. Derartige Verfahren sind beispielsweise in dem "Handbook of MRI Pulse Sequences"; Bernstein, King, Zhou; Elsevier Academic Press, ISBN-13:978-0-12-092861-3, Kapitel 13.2 beschrieben. Auf diese Weise kann ein Magnetresonanzsignal zumindest näherungsweise bestimmt werden, dass von dem Patienten 100 ausgesendet wird, während in einem Schritt S10 das Referenzstörsignal mit dem Störsignalsensor 60 aufgenommen wird.

In einer anderen in Fig. 3 dargestellten beispielhaften Ausführungsform ist es denkbar, dass mit einer Magnetresonanzmessung S33 quantitative Informationen über das zu untersuchende Objekt erfasst werden. Dies könnte beispielsweise eine Spindichte der Kernspins pro Volumenelement sein. Aus diesen quantitativen Informationen wird in einem Schritt S33 ein Anteil des Magnetresonanzsignals in dem in Schritt S10 empfangenen Referenzstörsignal bestimmt. Dabei kann in einem Schritt S34 mittels der quantitativen Information eine Größe des während des Schrittes S10 empfangenen Anteils des Magnetresonanzsignals beispielsweise durch eine Bloch-Simulation aus dieser Spindichte und einer anschließend darauf angewendeten Transferfunktion ermittelt werden.

Eine derartige Transferfunktion kann in einem Schritt S35 ermittelt werden. Denkbar ist dabei beispielsweise, dass die Transferfunktion mittels Maxwellscher Feldgleichungen simuliert wird, wenn die Empfangseigenschaften des Störsignalsensors 60, dessen Anordnung relativ zu dem Untersuchungsobjekt und die Eigenschaften des Untersuchungsobjektes bekannt sind.

Es wäre aber auch möglich, in einem Schritt S35 die Transferfunktion durch Messung zu ermitteln. Denkbar wäre es, bei einem bekannten Magnetresonanzsignal am Ort des Untersuchungsobjektes das Magnetresonanzsignal mittels Autokorrelation in dem Empfangssignal des Störsignalsensors 60 durch den Empfänger 70 zu detektieren und auf diesem Wege die Transferfunktion mit ihren wesentlichen Parametern zu ermitteln, insbesondere Dämpfung und Phasenverschiebung.

Denkbar wäre es auch, eine Messung des Signals des Störsignalsensors 60 bei gleicher Anregung der Spins, z.B. identischen Sequenzen zu wiederholen und aufzusummieren bzw. zu mitteln. Während ein statistisches Störsignal sich dabei mit zunehmender Anzahl der Wiederholungen durch die Mittelung heraushebt, nimmt die Stärke des Magnetresonanzsignals relativ dazu zu, sodass bei genügend langer Mittelung die Transferfunktion für das Magnetresonanzsignal mit ausreichender Genauigkeit ermittelt werden kann.

Der Schritt S35 kann dabei auch einer Kombination der beschriebenen Verfahren aufweisen, sodass beispielsweise auch periodische Störsignale das Verfahren nicht stören.

Auch kann der Schritt S35 zu unterschiedlichen Zeitpunkten ausgeführt werden. Die Transferfunktion kann beispielsweise einmalig für einen Typ eines Magnetresonanztomographen 1 ermittelt werden. Denkbar ist es aber auch vor einer bzw. jeder Bilderfassung oder auch zwischen einzelnen Sequenzen die Transferfunktion neu zu ermitteln oder anzupassen, um beispielsweise Änderungen durch Bewegungen des Patienten 100 als Untersuchungsobjekt berücksichtigen zu können.

Aus dem ermittelten Magnetresonanzsignal und der Transferfunktion kann dann jeweils ein in dem Signal des Störsignalsensors 60 zu erwartender Anteil des Magnetresonanzsignals zu jedem Zeitpunkt ermittelt werden. Wird dieser ermittelte Anteil dann beispielsweise mit umgekehrten Vorzeichen, d.h. mit einer Phasenverschiebung von 180 Grad, zu dem Signal des Störsignalsensors addiert, so hebt sich der Magnetresonanzsignalanteil idealerweise auf und man erhält ein reines Störsignal. Denkbar ist es aber auch, dass durch entsprechende Filtermaßnahmen im Empfänger 70 im nachfolgenden Signalweg in der analogen oder digitalen Signalverarbeitung der ermittelte Magnetresonanzsignalanteil berücksichtigt bzw. unterdrückt wird. Das kann beispielsweise mittels adaptive Filter erreicht werden.

Das Magnetresonanzsignal kann dabei durch unerwünschte Nebeneffekte, beispielsweise durch Variationen der Gradientenfelder durch Wirbelströme, von einem idealen Magnetresonanzsignal abweichen. In einer denkbaren Ausführungsform ist es deshalb vorgesehen, dass der Magnetresonanztomograph 1 eine Feldkamera 65 aufweist, mit der das Magnetfeld, bestehend aus dem statischen Anteil B0 und den Gradientenfeldern gemessen wird, vorzugsweise während des Schrittes S10 und /oder S20. Eine Feldkamera 65 kann beispielsweise mehrere Proben mit einem für Kernspinanregung sensitiven Material über den Patiententunnel verteilt aufweisen, deren Magnetresonanzsignal erfasst wird und so eine genau Bestimmung der Magnetfelder am Ort der Feldproben erlaubt. Durch Interpolation kann daraus auch die Feldstärke zwischen den Proben ermittelt werden. Denkbar wäre es auch, das Magnetfeld durch Magnetfeldsensoren wie Hall-Sensoren zu ermitteln. Mit der ermittelten Feldstärke kann dann beispielsweise die Bloch-Simulation der Magnetresonanzsignale in dem Empfänger 70 oder der Steuerung 23 genauer erfolgen und auf diese Weise dann auch der Anteil des Magnetresonanzsignals in dem Signal des Störsignalsensors 60 besser unterdrückt werden.

In einer denkbaren Ausführungsform des erfindungsgemäßen Verfahrens weist der Magnetresonanztomograph eine Mehrzahl an Antennen zum Empfang des Magnetresonanzsignals auf. Die Mehrzahl an Antennen, vorzugsweise Lokalspulen 50 bzw. Antennenspulen einer Lokalspulenmatrix, erlaubt es, durch die unterschiedlichen relativen Positionen zueinander und zu dem Patienten 100 bzw. dem Untersuchungsobjekt, unterschiedliche Mischungen des selben Störsignals mit einem Magnetresonanzsignal auszuwerten, sodass zum einen in den Signalen der Antennen besser das Störsignal unterschieden und herausgefiltert werden kann und umgekehrt in der anderen Richtung in dem Signal des Störsignalsensors der Magnetresonanzsignalanteil erkannt und gefiltert werden kann. Beispielsweise ist bei benachbarten Antennen einer Lokalspulenmatrix das Störsignal wegen des geringen Abstandes zueinander im Vergleich zur Störsignalquelle außerhalb des Patiententunnels 16 näherungsweise gleich, während sich die Magnetresonanzsignale für unterschiedliche Volumina des Patienten 100 unterscheiden lassen. Dadurch kann dann bei der Simulation des Magnetresonanzanteils dieser für die unterschiedlichen Ursprungsorte genauer modelliert und anschließen besser unterdrückt bzw. kompensiert werden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1. Verfahren zum Unterdrücken von Störsignalen bei einer Magnetresonanzaufnahme mit einem Magnetresonanztomographen (1), wobei der Magnetresonanztomograph (1) eine Steuerung (23), einen Empfänger (70), eine Antenne und einen Störsignalsensor (60) aufweist, wobei das Verfahren die Schritte aufweist:

    (S10) Empfangen eines Referenzstörsignals mit dem Empfänger (70) über den Störsignalsensor (60);
    (S20) Empfangen eines Magnetresonanzsignals eines Untersuchungsobjektes mit dem Empfänger (70) über die Antenne;
    (S30) Reduzieren eines Anteils des Störsignals in dem Magnetresonanzsignal durch den Empfänger (70) in Abhängigkeit von dem Referenzstörsignal,
    wobei das Reduzieren des Störsignals in Abhängigkeit von einem Anteil des Magnetresonanzsignals in dem von dem Störsignalsensor (60) empfangenen Referenzstörsignal erfolgt, **dadurch gekennzeichnet, dass**
    das Verfahren weiterhin die Schritte aufweist,
    (S31) mittels einer MR-Messung einen k-Raum mit Messdaten einer Bilderfassung zu füllen und (S32) einen Anteil des Magnetresonanzsignals in dem Referenzstörsignal mit Hilfe von Gridding auf den Messdaten im k-Raum zu interpolieren.

2. Verfahren zum Unterdrücken von Störsignalen bei einer Magnetresonanzaufnahme mit einem Magnetresonanztomographen (1), wobei der Magnetresonanztomograph (1) eine Steuerung (23), einen Empfänger (70), eine Antenne und einen Störsignalsensor (60) aufweist, wobei das Verfahren die Schritte aufweist:

(S10) Empfangen eines Referenzstörsignals mit dem Empfänger (70) über den Störsignalsensor (60);
(S20) Empfangen eines Magnetresonanzsignals eines Untersuchungsobjektes mit dem Empfänger (70) über die Antenne;
(S30) Reduzieren eines Anteils des Störsignals in dem Magnetresonanzsignal durch den Empfänger (70) in Abhängigkeit von dem Referenzstörsignal,
wobei das Reduzieren des Störsignals in Abhängigkeit von einem Anteil des Magnetresonanzsignals in dem von dem Störsignalsensor (60) empfangenen Referenzstörsignal erfolgt,
**dadurch gekennzeichnet, dass** das Verfahren weiterhin die Schritte aufweist,
(S33) mittels einer Magnetresonanzmessung quantitative Informationen über das Untersuchungsobjekt zu ermitteln und
(S34) einen Anteil des Magnetresonanzsignals in dem Referenzstörsignal mittels Simulation des Magnetresonanzsignals mit den quantitativen Informationen zu bestimmen.

3. Verfahren zum Unterdrücken von Störsignalen bei einer Magnetresonanzaufnahme mit einem Magnetresonanztomographen (1), wobei der Magnetresonanztomograph (1) eine Steuerung (23), einen Empfänger (70), eine Antenne und einen Störsignalsensor (60) aufweist, wobei das Verfahren die Schritte aufweist:

(S10) Empfangen eines Referenzstörsignals mit dem Empfänger (70) über den Störsignalsensor (60);
(S20) Empfangen eines Magnetresonanzsignals eines Untersuchungsobjektes mit dem Empfänger (70) über die Antenne;
(S30) Reduzieren eines Anteils des Störsignals in dem Magnetresonanzsignal durch den Empfänger (70) in Abhängigkeit von dem Referenzstörsignal,
wobei das Reduzieren des Störsignals in Abhängigkeit von einem Anteil des Magnetresonanzsignals in dem von dem Störsignalsensor (60) empfangenen Referenzstörsignal erfolgt,
**dadurch gekennzeichnet, dass** der Magnetresonanztomograph (1) eine Mehrzahl an Antennen zum Empfang des Magnetresonanzsignals aufweist,
wobei in dem Schritt (S30) des Reduzierens eines Anteils des Störsignals in dem Magnetresonanzsignal einer ersten Antenne durch den Empfänger (70) dies in Abhängigkeit von dem Referenzstörsignal und einem Magnetresonanzsignal einer zweiten Antenne erfolgt,
wobei ein Magnetresonanzsignal, das jeweils von erster Antenne und zweiter Antenne erfasst wird, mit entsprechender Phasenverzögerung eintrifft, sodass das Magnetresonanzsignal an dem Störsignalsensor (60) durch eine gewichtete Summe über die erste Antenne und die zweite Antenne mit jeweils unterschiedlicher Phasenverschiebung näherungsweise abgeschätzt wird, um es dann von dem empfangenen Signal des Störsignalsensors (60) abzuziehen.

4. Verfahren nach Anspruch 1 oder 2, wobei das Verfahren einen Schritt (S35) aufweist, eine Transferfunktion des Magnetresonanzsignals von dem Untersuchungsobjekt zu dem Störsignalsensor (60) zu bestimmen.

5. Verfahren nach einem der Ansprüche 1 bis 4, wobei der Magnetresonanztomograph (1) eine Feldkamera (65) aufweist und das Verfahren weiterhin den Schritt aufweist, während Empfangens des Magnetresonanzsignals (S20) den zeitlichen Verlauf eines Gradientenfeldes mittels der Feldkamera (65) aufzuzeichnen, wobei der Anteil des Magnetresonanzsignals in dem Referenzstörsignal in Abhängigkeit von dem von der Feldkamera (65) aufgezeichneten zeitlichen Verlaufs des Gradientenfeldes bestimmt wird.

6. Magnetresonanztomograph mit einer Steuerung (23), einem Empfänger (70), einer Antenne und einem Störsignalsensor (60), wobei der Magnetresonanztomograph (1) ausgelegt ist, ein Referenzstörsignal mit dem Empfänger (70) über den Störsignalsensor (60) zu empfangen;

ein Magnetresonanzsignal eines Untersuchungsobjektes mit dem Empfänger (70) über die Antenne zu empfangen;
mit dem Empfänger (70) einen Anteil des Störsignals in dem Magnetresonanzsignal in Abhängigkeit von dem Referenzstörsignal zu reduzieren, wobei das Reduzieren des Störsignals in Abhängigkeit von einem Anteil des Magnetresonanzsignals in dem von dem Störsignalsensor (60) empfangenen Referenzstörsignal erfolgt,

**dadurch gekennzeichnet, dass**

die Steuerung (23) weiterhin ausgelegt ist, mittels einer MR-Messung einen k-Raum mit Messdaten einer Bilderfassung zu füllen und einen Anteil des Magnetresonanzsignals in dem Referenzstörsignal mit Hilfe von Gridding auf den Messdaten im k-Raum zu interpolieren.

7. Magnetresonanztomograph mit einer Steuerung (23), einem Empfänger (70), einer Antenne und einem Störsignalsensor (60), wobei der Magnetresonanztomograph (1) ausgelegt ist, ein Referenzstörsignal mit dem Empfänger (70) über den Störsignalsensor (60) zu empfangen;

ein Magnetresonanzsignal eines Untersuchungsobjektes mit dem Empfänger (70) über die Antenne zu empfangen;

mit dem Empfänger (70) einen Anteil des Störsignals in dem Magnetresonanzsignal in Abhängigkeit von dem Referenzstörsignal zu reduzieren, wobei das Reduzieren des Störsignals in Abhängigkeit von einem Anteil des Magnetresonanzsignals in dem von dem Störsignalsensor (60) empfangenen Referenzstörsignal erfolgt,

**dadurch gekennzeichnet, dass**

die Steuerung (23) weiterhin ausgelegt ist, mittels einer Magnetresonanzmessung quantitative Informationen über das zu Untersuchungsobjekt zu ermitteln und einen Anteil des Magnetresonanzsignals in dem Referenzstörsignal mittels Simulation des Magnetresonanzsignals mit den quantitativen Informationen zu bestimmen.

8. Magnetresonanztomograph mit einer Steuerung (23), einem Empfänger (70), einer Antenne und einem Störsignalsensor (60), wobei der Magnetresonanztomograph (1) ausgelegt ist, ein Referenzstörsignal mit dem Empfänger (70) über den Störsignalsensor (60) zu empfangen;

ein Magnetresonanzsignal eines Untersuchungsobjektes mit dem Empfänger (70) über die Antenne zu empfangen;

mit dem Empfänger (70) einen Anteil des Störsignals in dem Magnetresonanzsignal in Abhängigkeit von dem Referenzstörsignal zu reduzieren, wobei das Reduzieren des Störsignals in Abhängigkeit von einem Anteil des Magnetresonanzsignals in dem von dem Störsignalsensor (60) empfangenen Referenzstörsignal erfolgt,

**dadurch gekennzeichnet, dass**

der Magnetresonanztomograph eine Mehrzahl an Antennen zum Empfang des Magnetresonanzsignals aufweist,

die Steuerung (23) weiterhin ausgelegt ist, bei dem Reduzieren eines Anteils des Störsignals in dem Magnetresonanzsignal einer ersten Antenne durch den Empfänger (70) dies in Abhängigkeit von dem Referenzstörsignal und einem Magnetresonanzsignal einer zweiten Antenne erfolgt,

wobei ein Magnetresonanzsignal, das jeweils von erster Antenne und zweiter Antenne erfasst wird, mit entsprechender Phasenverzögerung eintrifft, wobei die Steuerung (23) ausgelegt ist, das Magnetresonanzsignal an dem Störsignalsensor (60) durch eine gewichtete Summe über die erste Antenne und die zweite Antenne mit jeweils unterschiedlicher Phasenverschiebung näherungsweise abzuschätzen, um es dann von dem empfangenen Signal des Störsignalsensors (60) abzuziehen.

9. Computerprogrammprodukt, welches direkt in einen Prozessor einer programmierbaren Steuerung (23) eines Magnetresonanztomographen (1) gemäß der Präambel eines der Ansprüche 6 bis 8 ladbar ist, mit Programmcode-Mitteln, um alle Schritte eines Verfahrens nach einem der Ansprüche 1 bis 5 auszuführen, wenn das Programmprodukt auf der Steuerung (23) ausgeführt wird.

10. Computerlesbares Speichermedium mit darauf gespeicherten elektronisch lesbaren Steuerinformationen, welche derart ausgestaltet sind, dass sie bei Verwendung des Speichermediums in einer Steuerung (23) eines Magnetresonanztomographen (1) gemäß der Präambel eines der Ansprüche 6 bis 8 das Verfahren nach einem der Ansprüche 1 bis 5 durchführen.

**Claims**

1. Method for suppressing interference signals in a magnetic resonance recording with a magnetic resonance tomography scanner (1), wherein the magnetic resonance tomography scanner (1) has a controller (23), a receiver (70), an antenna and an interference signal sensor (60), wherein the method has the steps:

(S10) receiving a reference interference signal by means of the receiver (70) via the interference signal sensor (60);

(S20) receiving a magnetic resonance signal of an examination object by means of the receiver (70) via the antenna;

(S30) reducing a portion of the interference signal in the magnetic resonance signal by means of the receiver (70) as a function of the reference interference signal,

wherein the reduction of the interference signal takes place as a function of a portion of the magnetic resonance signal in the reference interference signal received by the interference signal sensor (60),

**characterised in that**

the method further has the steps

(S31) populating a k-space with scan data of an image acquisition by means of an MR scan, and

(S32) interpolating a portion of the magnetic resonance signal in the reference interference signal onto the scan data in the k-space with the aid of gridding.

2. Method for suppressing interference signals in a magnetic resonance recording with a magnetic resonance tomography scanner (1), wherein the magnetic resonance tomography scanner (1) has a controller (23), a receiver (70), an antenna and an interference signal sensor (60), wherein the method has the steps:

(S10) receiving a reference interference signal by means of the receiver (70) via the interference signal sensor (60);

(S20) receiving a magnetic resonance signal of an examination object by means of the receiver (70) via the antenna;

(S30) reducing a portion of the interference signal in the magnetic resonance signal by means of the receiver (70) as a function of the reference interference signal,

wherein the reduction of the interference signal takes place as a function of a portion of the magnetic resonance signal in the reference interference signal received by the interference signal sensor (60),

**characterised in that** the method further has the steps,

(S33) determining quantitative information about the examination object by means of a magnetic resonance scan, and

(S34) determining a portion of the magnetic resonance signal in the reference interference signal by simulating the magnetic resonance signal with the quantitative information.

3. Method for suppressing interference signals in a magnetic resonance recording with a magnetic resonance tomography scanner (1), wherein the magnetic resonance tomography scanner (1) has a controller (23), a receiver (70), an antenna and an interference signal sensor (60), wherein the method has the steps:

(S10) receiving a reference interference signal by means of the receiver (70) via the interference signal sensor (60);

(S20) receiving a magnetic resonance signal of an examination object by means of the receiver (70) via the antenna;

(S30) reducing a portion of the interference signal in the magnetic resonance signal by means of the receiver (70) as a function of the reference interference signal,

wherein the reduction of the interference signal takes place as a function of a portion of the magnetic resonance signal in the reference interference signal received by the interference signal sensor (60),

**characterised in that** the magnetic resonance tomography scanner (1) has a plurality of antennae for receiving the magnetic resonance signal,

wherein in the step (S30) of reducing a portion of the interference signal in the magnetic resonance signal of a first antenna by means of the receiver (70), this takes place as a function of the reference interference signal and a magnetic resonance signal of a second antenna,

wherein a magnetic resonance signal, which is detected by a first antenna and second antenna in each case, arrives with a corresponding phase delay, so that the magnetic resonance signal on the interference signal sensor (60) is approximately estimated by a weighted sum across the first antenna and the second antenna with in each case a different phase shift in order then to subtract it from the received signal of the interference signal sensor (60).

4. Method according to claim 1 or 2, wherein the method has a step (S35) to determine a transfer function of the magnetic resonance signal from the examination object to the interference signal sensor (60).

5. Method according to one of claims 1 to 4, wherein the magnetic resonance tomography scanner (1) has a field camera (65) and the method further has the step of recording the temporal sequence of a gradient field by means of the field camera (65) while receiving the magnetic resonance signal (S20), wherein the portion of the magnetic resonance signal in the reference interference signal is determined as a function of the temporal sequence of the gradient field recorded by the field camera (65).

6. Magnetic resonance tomography scanner with a controller (23), a receiver (70), an antenna and an interference signal sensor (60), wherein the magnetic resonance tomography scanner (1) is configured to

receive a reference interference signal by means of the receiver (70) via the interference signal sensor (60); receive a magnetic resonance signal of an examination object by means of the receiver (70) via the antenna;

reduce a portion of the interference signal in the magnetic resonance signal as a function of the reference interference signal by means of the receiver (70), wherein the reduction of the interference signal takes place as a function of a portion of the magnetic resonance signal in the reference interference signal received by the interference signal sensor (60),

**characterised in that**

the controller (23) is further configured to populate a k-space with scan data of an image acquisition by means of an MR scan, and

to interpolate a portion of the magnetic resonance signal in the reference interference signal onto the scan data in the k-space with the aid of gridding.

7. Magnetic resonance tomography scanner with a controller (23), a receiver (70), an antenna and an interference signal sensor (60), wherein the magnetic resonance tomography scanner (1) is configured to

receive a reference interference signal by means of the receiver (70) via the interference signal sensor (60); receive a magnetic resonance signal of an examination object by means of the receiver (70) via the antenna;

reduce a portion of the interference signal in the magnetic resonance signal as a function of the reference interference signal by means of the receiver (70), wherein the reduction of the interference signal takes place as a function of a portion of the magnetic resonance signal in the reference interference signal received by the interference signal sensor (60),

**characterised in that**

the controller (23) is further configured

to determine quantitative information about the examination object by means of a magnetic resonance scan, and

to determine a portion of the magnetic resonance signal in the reference interference signal by simulating the magnetic resonance signal with the quantitative information.

8. Magnetic resonance tomography scanner with a controller (23), a receiver (70), an antenna and an interference signal sensor (60), wherein the magnetic resonance tomography scanner (1) is configured to

receive a reference interference signal by means of the receiver (70) via the interference signal sensor (60); receive a magnetic resonance signal of an examination object by means of the receiver (70) via the antenna;

reduce a portion of the interference signal in the magnetic resonance signal as a function of the reference interference signal by means of the receiver (70), wherein the reduction of the interference signal takes place as a function of a portion of the magnetic resonance signal in the reference interference signal received by the interference signal sensor (60),

**characterised in that**

the magnetic resonance tomography scanner has a plurality of antennae for receiving the magnetic resonance signal,

the controller (23) is further configured,

when reducing a portion of the interference signal in the magnetic resonance signal of a first antenna by means of the receiver (70), for this to take place as a function of the reference interference signal and a magnetic resonance signal of a second antenna,

wherein a magnetic resonance signal, which is detected by a first antenna and second antenna in each case, arrives with a corresponding phase delay, wherein the controller (23) is configured to approximately estimate the magnetic resonance signal on the interference signal sensor (60) by a weighted sum across the first antenna and the second antenna with in each case a different phase shift in order then to subtract it from the received signal of the interference signal sensor (60).

9. Computer program product which is loadable directly into a processor of a programmable controller (23) of a magnetic resonance tomography scanner (1) according to the preamble of one of claims 6 to 8, having program means in order to carry out all steps of a method as claimed in one of claims 1 to 5 when the program product is executed on the controller (23).

10. Computer-readable storage medium with electronically readable control information stored thereon, which is configured such that, when using the storage medium in a controller (23) of the magnetic resonance tomography scanner (1) according to the preamble of one of claims 6 to 8, it carries out the method according to one of claims 1 to 5.

**Revendications**

1. Procédé de suppression de signaux parasites, lors d'un enregistrement par résonnance magnétique par un tomodensitomètre (1) de résonnance magnétique, dans lequel le tomodensitomètre (1) de résonnance magnétique a une commande (23), un récepteur (70), une antenne et un capteur (60) de signal parasite, dans lequel le procédé a les stades :

(S10) réception d'un signal parasite de référence par le récepteur (70), par l'intermédiaire du capteur (60) de signal parasite ;

(S20) réception par le récepteur (70) par l'intermédiaire de l'antenne d'un signal de résonnance magnétique d'un objet à examiner ;

(S30) réduction d'une proportion du signal parasite, dans le signal de résonnance magnétique, par le récepteur (70) en fonction du signal parasite de référence,

dans lequel la réduction du signal parasite s'effectue en fonction d'une proportion du signal de résonnance magnétique dans le signal parasite de référence reçu par le capteur (60) de signal parasite,

**caractérisé en ce que**

le procédé a en outre les stades,

(S31) au moyen d'une mesure RM, remplissage d'un espace k par des données de mesure d'une prise d'image, et

(S32) interpolation d'une proportion du signal de résonnance magnétique dans le signal parasite de référence, à l'aide d'un gridding sur les données de mesure dans l'espace k.

2. Procédé de suppression de signaux parasites, lors d'un enregistrement par résonnance magnétique par un tomodensitomètre (1) de résonnance magnétique, dans lequel le tomodensitomètre (1) de résonnance magnétique a une commande (23), un récepteur (70), une antenne et un capteur (60) de signal parasite, dans lequel le procédé a les stades :

(S10) réception d'un signal parasite de référence par le récepteur (70), par l'intermédiaire du capteur (60) de signal parasite ;

(S20) réception d'un signal de résonnance magnétique d'un objet à examiner par le récepteur (70), par l'intermédiaire de l'antenne ;

(S30) réduction d'une proportion du signal parasite, dans le signal de résonnance magnétique, par le récepteur (70) en fonction du signal parasite de référence,

dans lequel la réduction du signal parasite s'effectue, en fonction d'une proportion du signal de résonnance magnétique dans le signal parasite de référence reçu par le capteur (60) de signal parasite,

**caractérisé en ce que**

le procédé a en outre les stades,

(S33) détermination, au moyen d'une mesure de résonnance magnétique, d'informations quantitatives sur l'objet à examiner, et

(S34) définition d'une proportion du signal de résonnance magnétique dans le signal parasite de référence, au moyen d'une simulation du signal de résonnance magnétique avec les informations quantitatives.

3. Procédé de suppression de signaux parasites, lors d'un enregistrement par résonnance magnétique par un tomodensitomètre (1) de résonnance magnétique, dans lequel le tomodensitomètre (1) de résonnance magnétique a une commande (23), un récepteur (70), une antenne et un capteur (60) de signal parasite, dans lequel le procédé a les stades :

(S10) réception d'un signal parasite de référence par le récepteur (70), par l'intermédiaire du capteur (60) de signal parasite ;

(S20) réception d'un signal de résonnance magnétique d'un objet à examiner par le récepteur (70) par l'intermédiaire de l'antenne ;

(S30) réduction d'une proportion du signal parasite, dans le signal de résonnance magnétique par le récepteur (70) en fonction du signal parasite de référence,

dans lequel la réduction du signal parasite s'effectue en fonction d'une proportion du signal de résonnance magnétique dans le signal parasite de référence reçu par le capteur (60) de signal parasite,

**caractérisé en ce que** le tomodensitomètre (1) de résonnance magnétique a une pluralité d'antennes de réception du signal de résonnance magnétique,

dans lequel, dans le stade (S30) de la réduction d'une proportion du signal parasite dans le signal de résonnance magnétique d'une première antenne par le récepteur (70), cela au lieu en fonction du signal parasite de référence et d'un signal de résonnance magnétique d'une deuxième antenne,

dans lequel un signal de résonnance magnétique, qui est détecté respectivement par la première antenne et la deuxième antenne,

intervient avec un retard de phase correspondant, de manière à ce que le signal de résonnance magnétique au capteur (60) du signal parasite soit estimé approximativement par une somme pondérée, par l'intermédiaire de la première antenne et de la deuxième antenne,

avec un décalage de phase différent respectivement, afin de le déduire alors du signal reçu du capteur (60) du signal parasite.

4. Procédé suivant la revendication 1 ou 2, dans lequel le procédé a un stade (S35) de détermination d'une fonction de transfert du signal de résonnance magnétique de l'objet à examiner au capteur (60) de signal parasite.

5. Procédé suivant l'une des revendications 1 à 4, dans lequel le tomodensitomètre (1) de résonnance magnétique a une caméra (65) de champ et le procédé comprend en outre le stade d'enregistrement, pendant la réception du signal (S20) de résonance magnétique, de la courbe en fonction du temps d'un champ de gradient, au moyen de la caméra (65) de champ, dans lequel on détermine la proportion du signal de résonance magnétique dans le signal parasite de référence en fonction de la courbe temporelle du champ de gradients enregistrée par la caméra (65) de champ.

6. Tomodensitomètre à résonance magnétique, comprenant une commande (23), un récepteur (70) et un capteur (60) de signal parasite, dans lequel le tomodensitomètre (1) à résonnance magnétique est conçu

pour recevoir un signal parasite de référence par le récepteur (70), par l'intermédiaire du capteur (60) de signal parasite ;
pour recevoir un signal de résonance magnétique d'un objet à examiner par le récepteur (70), par l'intermédiaire de l'antenne ;
pour réduire, par le récepteur (70), une proportion du signal parasite dans le signal de résonance magnétique, en fonction du signal parasite de référence, dans lequel la réduction du signal parasite en fonction d'une proportion du signal de résonance magnétique, a lieu dans le signal parasite de référence reçu par le capteur (60) de signal parasite,
**caractérisé en ce que**
la commande (23) est conçue en outre
pour remplir, au moyen d'une mesure RM, un espace k de données de mesure d'une prise d'image, et
pour interpoler une proportion du signal de résonance magnétique dans le signal parasite de référence, à l'aide d'un gridding sur les données de mesure dans l'espace k.

7. Tomodensitomètre à résonance magnétique, comprenant une commande (23), un récepteur (70) et un capteur (60) de signal parasite, dans lequel le tomodensitomètre (1) de résonnance magnétique est conçu

pour recevoir un signal parasite de référence, par le récepteur (70) par l'intermédiaire du capteur (60) de signal parasite ;
pour recevoir un signal de résonance magnétique d'un objet à examiner par le récepteur (70) par l'intermédiaire de l'antenne ;
pour réduire, par le récepteur (70), une proportion du signal parasite dans le signal de résonnance magnétique, en fonction du signal parasite de référence, dans lequel la réduction du signal parasite, en fonction d'une proportion du

signal de résonance magnétique, a lieu dans le signal parasite de référence reçu par le capteur (60) de signal parasite,
**caractérisé en ce que**
la commande (23) est conçue en outre
pour déterminer, au moyen d'une mesure de résonnance magnétique, des informations quantitatives sur l'objet à examiner, et
pour définir une proportion du signal de résonnance magnétique dans le signal parasite de référence, au moyen d'une simulation du signal de résonance magnétique par les informations quantitatives.

8. Tomodensitomètre à résonance magnétique, comprenant une commande (23), un récepteur (70) et un capteur (60) de signal parasite, dans lequel le tomodensitomètre (1) de résonnance magnétique est conçu

pour recevoir un signal parasite de référence par le récepteur (70), par l'intermédiaire du capteur (60) de signal parasite ;
pour recevoir un signal de résonance magnétique d'un objet à examiner par le récepteur (70) par l'intermédiaire de l'antenne ; pour réduire, par le récepteur (70), une proportion du signal parasite dans le signal de résonance magnétique, en fonction du signal parasite de référence, dans lequel la réduction du signal parasite, en fonction d'une proportion du signal de résonnance magnétique, a lieu dans le signal parasite de référence reçu par le capteur (60) de signal parasite,
**caractérisé en ce que**
le tomodensitomètre de résonance magnétique a une pluralité d'antennes de réception du signal de résonance magnétique,
la commande (23) est conçue en outre
lors de la réduction d'une proportion du signal parasite dans le signal de résonance magnétique d'une première antenne par le récepteur (70), cela a lieu en fonction du signal parasite de référence et d'un signal de résonance magnétique d'une deuxième antenne,
dans lequel un signal de résonance magnétique, que l'on détecte respectivement par la première antenne et la deuxième antenne, intervient avec un retard de phase correspondant,
dans lequel la commande (23) est conçue pour estimer approximativement le signal de résonnance magnétique au capteur (60) de signal parasite par une somme pondérée, par l'intermédiaire de la première antenne et de la deuxième antenne, ayant respectivement un déphasage différent, pour le déduire alors du signal reçu du capteur (60) de signal parasite.

**9.** Produit de programme d'ordinateur, qui peut être chargé directement dans un processeur d'une commande (23) programmable d'un tomodensitomètre (1) de résonnance magnétique, suivant le préambule de l'une des revendications 6 à 8, comprenant des moyens de code de programme pour effectuer tous les stades d'un procédé suivant l'une des revendications 1 à 5, lorsque le produit de programme est réalisé sur la commande (23).

**10.** Support de mémoire, déchiffrable par ordinateur, sur laquelle sont mises en mémoire des informations de commande déchiffrables électroniquement, qui sont conformées de manière à ce qu'elles effectuent, lors de l'utilisation du support de mémoire ou d'une commande (23) d'un tomodensitomètre (1) de résonnance magnétique, suivant le préambule de l'une des revendications 6 à 8, le procédé suivant l'une des revendications 1 à 5.

# FIG 1

# FIG 2

S10

S20

S30

S31

S32

S35

# FIG 3

S10

S20

S30

S33

S34

S35

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3467531 A
- JP 2018201599 A

- US 20080048658 A1

**In der Beschreibung aufgeführte Nicht-Patentliteratur**

- **BERNSTEIN, KING, ZHOU.** Handbook of MRI Pulse Sequences. Elsevier Academic Press